# EUROPEAN PATENT APPLICATION

(11) **EP 3 435 542 A1**
(43) Date of publication of application: **30.01.2019**
(21) Application number: 17183228.0
(22) Date of filing: 26.07.2017
(51) Int. Cl.: H03H 11/46, H03H 11/48

(54) **ELECTRICAL CIRCUIT FOR EMULATING VARIABLE ELECTRICAL CHARACTERISTICS**

(71) Applicant: ASML Netherlands B.V., 5500 AH Veldhoven (NL)
(72) Inventor: VAN WANROOIJ, Jeroen, Earl, 5500 AH Veldhoven (NL)
(74) Representative: Peters, John Antoine

(57) **Abstract**

An electronic circuit configured to emulate an impedance, the electronic circuit comprising:
a first inverting amplifier (Opamp1) comprising a first feedback circuit;
a second inverting amplifier (Opamp2) comprising a second feedback circuit; and
a component (DAC) having an input connected to an output of the first inverting amplifier and an output connected to an inverting input of the second inverting amplifier, wherein the component is configured to convert a voltage (Vref_in) to a current (I_out) which is adjustable by modification of a setting (setpoint) of the component;
wherein the emulated impedance (R_out) of the electronic circuit is defined between an inverting input of the first inverting amplifier and an output of the second inverting amplifier and adjustable by modification of the setting of the component.

## Description

### BACKGROUND

### Field of the invention

The invention relates to electrical circuits configured to emulate variable electrical impedance of a component. The impedance may be complex valued and hence a variable resistance, inductance or capacitance may be emulated.

### Related Art

In many occasions, it is desired to provide an electrical circuit with a component configured to be able to adopt a variable resistance, variable inductance or a variable capacitance. A typical variable resistance component for example comprises a plurality of accurately manufactured resistors, one contact of each resistor is connected to a central reference and a switch providing selection of the current to run through a selected resistor out of the plurality of resistors. In other words, the plurality of resistors forms a parallel network of resistors, in which an electrical current may be diverted through a selectable resistor out of the plurality of resistors. In a similar fashion, switchable parallel networks of capacitors and inductors may be used to provide a variable capacitance or inductance component. A disadvantage of currently variable resistors (circuits) is that the number of selectable resistance values is generally limited as typically constraints apply to the number of components (resistors, switches) that can be placed on a printed circuit board (PCB). Additionally, such a variable resistance circuit may be expensive to manufacture when the desired resistance value needs to be within a narrow range. In the latter case, a potentially high amount of expensive low tolerance resistors need to be utilized.

### SUMMARY OF THE INVENTION

The invention aims to provide a circuit configured to be able to simulate a selectable electrical characteristic out of many selectable electrical characteristic values, the circuit utilizing low cost components, many of which are utilized frequently on standard PCB's. It is a further objective to utilize standard component, to keep costs low and ensure compatibility with existing circuits of components applied to the PCB for which the variable electrical characteristic functionality needs to be provided.

In a first aspect of the invention an electronic circuit configured to emulate an impedance is disclosed, the electronic circuit comprising: a first inverting amplifier comprising a first feedback circuit; a second inverting amplifier comprising a second feedback circuit; and a component having an input connected to an output of the first inverting amplifier and an output connected to an inverting input of the second inverting amplifier, wherein the component is configured to convert a voltage to a current which is adjustable by modification of a setting of the component, wherein the emulated impedance of the electronic circuit is defined between an inverting input of the first inverting amplifier and an output of the second inverting amplifier and adjustable by modification of the setting of the component.

### BRIEF DESCRIPTION OF THE DRAWINGS

Embodiments of the invention will now be described, by way of example only, with reference to the accompanying schematic drawings in which:
Figure 1 illustrates a schematic circuit of a variable resistor according to the state of the art.
Figure 2 illustrates an embodiment of the invention; a circuit configured to emulate a variable impedance.

### DETAILED DESCRIPTION OF EXEMPLARY EMBODIMENTS

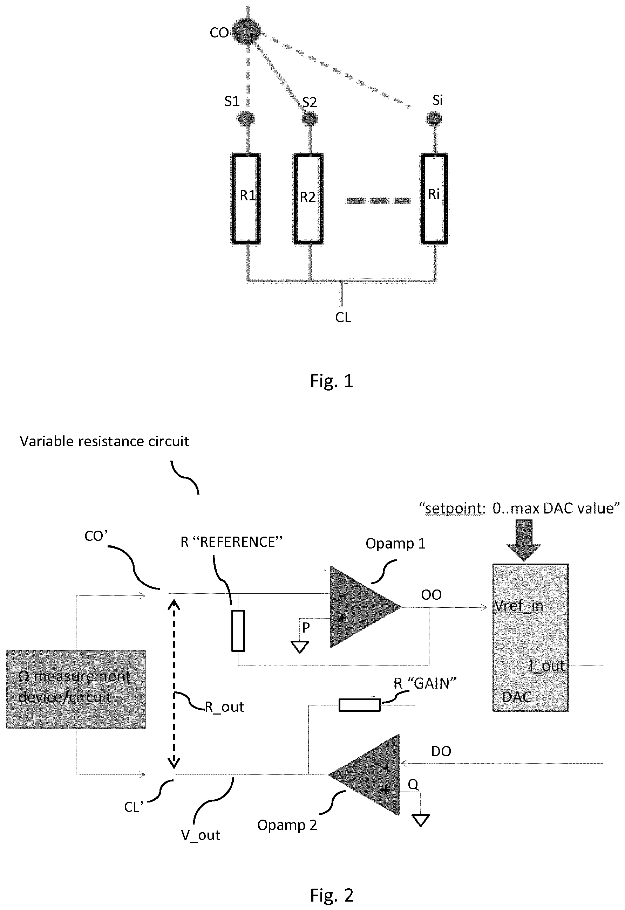

Typically, variable resistors are used for calibration and/or electrical testing purposes. The response of the variable resistor to, for example a measurement device (multimeter) configured to measure an Ohmic resistance, may be used to determine an exact value of the resistance for a certain setting of the variable resistor. In general, the measurement device (when configured as an Ohmic measurement device) measures a current (Ampere) and a voltage across two contacts connected to the circuit or component of interest. Using Ohm's law, the resistance is then determined (Resistance =V/I, V being the voltage and I being the current). A variable resistor according to figure 1 comprises a parallel network of resistors, wherein the network is switchable (switches S1, S2, .., Si) between a plurality of resistors, each of the resistors in general having an accurately designed resistance value. The contacts between which the resistance is measured are denoted by 'CL' and 'CO'. The voltage 'V' delivered by the measurement device is normally fairly constant, hence switching between the various resistors 'R1', 'R2', ..,'Ri' leads to a change in the measured current 'I' which is then used to determine the resistance. From figure 1 it is understood that a known variable resistor circuit potentially may comprise many components (resistors, switches).

A variable resistance circuit is proposed being adjustable to a wide range of resistance values without using many components. Figure 2 illustrates a variable resistance circuit according to an embodiment of the invention. A first pole of the measurement device is connected to the inverting input 'CO" of a first Operational Amplifier (Opamp 1). The first Opamp forces the first pole 'CO' to a zero potential (virtual ground, the second pole 'P' of the first Opamp is grounded). The voltage at the output 'OO' is proportional to the current provided by the measurement device multiplied by the reference resistance R "REFERENCE" which is incorporated within the feedback circuit (OO-CO') of the first Opamp. The utilized configuration of the first Opamp is commonly referred to as an "inverting amplifier" as the voltage at the output of the Opamp is basically inverted (reversed sign) with respect to the input voltage. The output voltage at the output 'OO' is further scaled in a controllable manner using a DAC -second Opamp tandem. The output 'OO' is connected to the input 'Vref_in' of the DAC, which typically provides a current 'I_out' at the output of the DAC which is scalable by adjusting a setting of the DAC ("setpoint" of the DAC).. In case the DAC requires a certain polarity of the input (Vref_in) a voltage inverting component (not shown) may need to be placed between the output 'OO' and the input of the DAC.

The DAC output is buffered with a second Opamp "Opamp 2". Opamp 2 has a gain = "fixed_GAIN" and the second pole 'Q' is grounded (in analogy to Opamp 1, hence Opamp 2 is also an inverting amplifier). The gain is controlled by the resistance of the resistor R "GAIN" which is incorporated within the feedback circuit (DO-CL') of the second Opamp. When connecting the second pole of the measurement device to CL' it will measure a voltage "V_out" between the contacts 'CO" and 'CL" proportional to its own measurement current, the reference resistance of the resistor R "REFERENCE", the DAC setting "setpoint" and the GAIN "fixed_GAIN". A measurement device operated to determine an Ohmic resistance and connected to the contacts 'CO' and 'CL' will then measure a resistance 'R_out' provided by the variable resistor circuit.

Controlling the voltage may be done electronically, while the components are standard and often already present on circuit boards (PCB) in case the variable resistor circuit is intended to be placed on existing electrical circuitry. The described circuit provides an accurately controllable voltage between the contacts 'CO" and 'CL" which scales exactly with the current provided to the circuit. In case of a resistance measurement the measurement device will register a controllable voltage "V_out", which will be interpreted as the accurately controllable resistance R_out:
R_out = R "REFERENCE" * setpoint * fixed_GAIN
A wide range of R_out are selectable by controlling the DAC value (setpoint of the DAC):
Of 0Ω: (setpoint * Fixed_GAIN) = 0
Far below R reference: (setpoint * Fixed_GAIN) « 1
Around R reference: (setpoint * Fixed_GAIN) = 1
Far above R reference: (setpoint * Fixed_GAIN) » 1

The key part of the circuit is the first Opamp which is connected in such a way that it generates a virtual-ground on the input terminal 'CO'. This subtracts the measurement offset voltage in R reference (due to the measurement current), that otherwise always would be present, and would force a value equal to R reference into the equation:

R_out_without_first_Opamp = R reference + (R "REFERENCE" * setpoint * Fixed_GAIN)

Next, the subtracted voltage (equal to measurement current * R "REFERENCE") is fed to the reference voltage input of a DAC. Depending on the setting of the DAC (0..full scale) that reference voltage is scaled. The final GAIN is done with an I to V converter (needed for the DAC), which functionality is provided by the second Opamp circuit.

The final gain may be done with 2 amplifiers (instead of one second Opamp), for extra buffering for example.

In case the feedback circuit(s) of the first Opamp and/or second Opamp have no known values the variable impedance circuit may still be utilized to emulate a (relative) impedance change. Hence the minimum configuration of a variable impedance emulating circuit would comprise two inverting amplifiers having a feedback circuit, both inverted amplifiers connected by a component converting the output voltage of the first inverting amplifier to a current which is provided to an inverting input of the second inverting amplifier. The emulated impedance is then defined between the inverting input CO' of the first inverting amplifier and an output of the second inverting amplifier, wherein the impedance may be changed by modification of a setting of the component (in case the component is a DAC, the DAC setting would scale the output current). In practical case such a variable voltage to current converting component is typically a Digital to Analog Converter (DAC).

In addition to providing variable resistance values the circuit of figure 2 may be adapted to also provide variable capacitance or variable inductance values. The reference resistor R "REFERENCE" may then be replaced by a reference capacitor or reference inductor. The current provided by the measurement device must then have an appropriate frequency in order to have the capacitor or inductor behave like a resistor. In general the variable resistance circuit may then be configured as a variable impedance circuit in case the reference resistor R "REFERENCE" does not have a real valued impedance but a complex valued impedance (the imaginary component of the impedance value associated with a capacitance and/or inductance). When providing an alternating current (by the measurement device) to the variable impedance circuit a resistance "R_out" will be measured which may be converted to a value of a resistance, capacitance or inductance.

The descriptions above are intended to be illustrative, not limiting. Thus, it will be apparent to one skilled in the art that modifications may be made to the invention as described without departing from the spirit and scope of the claims set out below. In addition, it should be appreciated that structural features or method steps shown or described in any one embodiment herein can be used in other embodiments as well.

## Claims

1. An electronic circuit configured to emulate an impedance, the electronic circuit comprising:
a first inverting amplifier comprising a first feedback circuit;
a second inverting amplifier comprising a second feedback circuit; and
a component having an input connected to an output of the first inverting amplifier and an output connected to an inverting input of the second inverting amplifier, wherein the component is configured to convert a voltage to a current which is adjustable by modification of a setting of the component;
,wherein the emulated impedance of the electronic circuit is defined between an inverting input of the first inverting amplifier and an output of the second inverting amplifier and adjustable by modification of the setting of the component.

2. An electronic circuit according to claim 1, wherein the first feedback circuit has a reference impedance.

3. An electronic circuit according to claim 1 or 2, wherein the second feedback circuit has a resistance configured to provide a desired gain of the second inverting amplifier.

4. The electronic circuit according to claim 2, wherein the values of the emulated impedance and the reference impedance are real valued numbers, the emulated impedance and reference impedance associated with values of an Ohmic resistance.

5. The electronic circuit according to claim 2, wherein the values of the variable impedance and the reference impedance are complex valued numbers, the emulated impedance and reference impedance associated with values of a capacitance.

6. The electronic circuit according to claim 2, wherein the values of the variable impedance and the reference impedance are complex valued numbers, the emulated impedance and reference impedance associated with values of an inductance.

7. The electronic circuit according to any preceding claim, wherein the component is a digital to analog converter (DAC).

8. The electronic circuit according to any preceding claim, wherein the second inverting amplifier comprises at least two inverted amplifiers in cascade.

9. The electronic circuit according to any preceding claim, comprising a voltage inverting circuit between an output of the first inverting amplifier and an input of the component.
